# EUROPÄISCHE PATENTANMELDUNG

(11) **EP 1 372 196 A1**
(43) Veröffentlichungstag der Anmeldung: **17.12.2003**
(21) Anmeldenummer: 02405466.0
(22) Anmeldetag: 10.06.2002
(51) Int. Cl.: H01L 29/739

(54) **Verfahren zum Ansteuern einer Leistungsdiode und Schaltungsanordnung zum Durchführen dieses Verfahrens**

(71) Anmelder: ABB Schweiz AG, 5400 Baden (CH)
(72) Erfinder: Apeldoorn, Oscar, 5618 Bettwil (CH); Steimer, Peter, 5424 Unterehrendingen (CH); Streit, Peter, 8967 Widen (CH)
(74) Vertreter: ABB Patent Attorneys

(57) **Zusammenfassung**

Ein Leistungshalbleiterbauelement weist zwischen zwei Leistungselektroden (2, 3) einen pn-Übergang auf. Im Bereich einer der beiden Leistungselektroden (3) ist eine Steuerelektrode (4) angeordnet. Über die Steuerelektrode kann ein Strom eingespiesen werden, mit welchem der Strom durch die Leistungselektroden angehoben werden kann. Im sperrenden Zustand des Bauelements kann dadurch der Sperrstrom angehoben werden.

Dies erlaubt die Serienschaltung mehrerer der erfindungsgemässen Leistungshalbleiterbauelemente ohne zusätzliche Snubberbeschaltung zum Schutz vor Überspannungen.

## Beschreibung

### Technisches Gebiet

Die Erfindung bezieht sich auf das Gebiet der Leistungselektronik. Sie betrifft ein Verfahren zum Ansteuern einer Leistungsdiode, sowie eine Schaltungsanordnung zum Durchführen dieses Verfahrens.

### Stand der Technik

Hochleistungs-Stromrichterschaltungen umfassen verschiedene leistungselektronische Bauelemente, beispielsweise Leistungsdioden und steuerbare Leistungshalbleiter aus den Familien der Thyristoren (GTO, Gate-Turn-Off Thyristor; GCT, Gate-Commutaded Thyristor, beschrieben in EP 0 588 026) oder Bipolartransistoren (Insulated-Gate Bipolartransistor, IGBT). Der Strom kann aktiv auf verschiedene Pfade in der Schaltung umkommutiert werden. Dabei treten in den abschaltbaren Halbleiter und in den Dioden statische und dynamische Verluste auf.

Wie bei allen Halbleitern können auch bei Dioden die Halbleiterparameter aufeinander abgestimmt werden, um möglichst attraktive statische und dynamische Daten zu erreichen. Solche Abstimmungen basieren beispielsweise auf:
- Trägerlebensdauer-Einstellung durch Elektronen, Gold, Platin oder andere Rekombinationszentren,
- axial oder lateral strukturierte Trägerlebensdauer,
- spezielle Kontrolle der Trägerlebensdauer im Randbereich,
- Emitter-Engineering homogener Art zur Beeinflussung der Plasmaverteilung im Durchlasszustand, oder
- fein strukturierte Emitter-Konfigurationen zur stromdichte-abhängigen Beeinflussung der Plasmaverteilung im Durchlasszustand.

Für die Dioden ist vor allem das Abschaltverhalten von Bedeutung. Beim Übergang vom leitenden in den sperrenden Zustand werden die grössten Verluste erzeugt.

Die Minimierung der dynamischen Schaltverluste durch entsprechende Auslegung der Diodenparameter führt zu unerwünschten Nebeneffekten:
- die Durchlassspannung der Diode und die damit verbundenen statischen Durchlassverluste steigen,
- beim Übergang vom leitenden in den sperrenden Zustand kann beim Ausräumen der Ladung im Bauelement der Anodenstrom sehr schnell auf Null abfallen. Die dadurch sehr schnell ansteigende Anoden-Kathodenspannung führt in der Stromrichterschaltung zu einer hohen Überspannung (> 6kV), die zur Zerstörung der verschiedenen Halbleiterbauelemente führen kann.

Stromrichteranwendungen mit sehr hohen Betriebsspannungen (DC-Link Spannungen von über 3.5 bis 5 kV) erfordern die Serieschaltung mehrerer Dioden. Die einzelnen Dioden weisen gewisse, leicht unterschiedliche Abweichungen von der idealen Diode auf, wodurch von Diode zu Diode leicht unterschiedliche Halbleiterparamter resultieren. Dies führt wiederum dazu, dass bei der Serienschaltung mehrere Dioden der Übergang vom leitenden in den sperrenden Zustand sowie der anschliessende ausgeschaltete Zustand besonders kritisch ist:
- der Leckstrom im ausgeschalteten, sperrenden Zustand ist zwar in allen Dioden gleich, durch die leicht unterschiedlichen Halbleiterparameter der Dioden können jedoch starke Unterschiede in der spannungsmässigen Belastung der einzelnen Dioden auftreten,
- die Sperrverzögerung im Übergang vom leitenden in den sperrenden Zustand ist von Diode zu Diode leicht verschieden,
- der Rückstrom (reverse-recovery Strom) in den Dioden kann abrupt abbrechen, und die Dioden entsprechende Schwingungen mit gefährlichen Überspannungen erzeugen, wobei der Abbruch von Diode zu Diode wiederum leicht verschieden ist.

Zur Kompensation dieser Effekte wird in herkömmlichen Stromrichterschaltungen der Serieschaltung mehrere Dioden eine passive Beschaltung, die sogenannte Snubberbeschaltung, parallelgeschaltet. Die Snubberschaltung (RC-Beschaltung) sorgt mit ihren passiven Bauelementen dafür, dass während eines Abschaltvorgangs und im darauf anschliessenden ausgeschalteten Zustand der Dioden die unterschiedlichen Halbleiterparameter der einzelnen Dioden nicht zu einer unzulässigen Spannungsverteilung über den einzelnen Dioden führen.

Eine derartige Snubberschaltung führt jedoch zu unerwünschten Nebeneffekten:
- es werden grosse Verluste erzeugt, und zwar unabhängig davon, ob die Halbleiterparameter sich stark unterscheiden oder fast gleich sind,
- es sind zusätzliche hochspannungsbelastete passive Bauelemente erforderlich, wodurch
- der Schaltungsaufwand erheblich steigt.

### Kurze Darstellung der Erfindung

Eine Aufgabe der Erfindung besteht darin, ein Verfahren zum Ansteuern einer Leistungsdiode sowie eine Schaltungsanordnung zum Durchführen dieses Verfahrens anzugeben, mit welchem Verfahren der durch die Leistungsanschlüsse fliessende Strom gesteuert werden kann.

Diese Aufgaben werden durch ein Verfahren und eine Schaltungsanordnung gemäss den Patentansprüchen 11 bzw. 15 und 16 gelöst.

Der Kern der Erfindung besteht darin, dass das Leistungshalbleiterbauelement Mittel zum dynamischen Beeinflussen der die Abweichung von der idealen Diode charakterisierenden Halbleiterparameter durch Stromeinspeisung in eine Steuerelektrode umfasst.

Der Leckstrom im erfindungsgemässen Leistungshalbleiterbauelement lässt sich mit diesen Mitteln nicht auf null reduzieren, aber er kann graduell erhöht werden. Damit werden zwar auch die Verluste im Bauteil zusätzlich erhöht, jedoch ergibt sich auf diese Weise die verlustarmste Anpassung der individuell unterschiedlichen Leckströme einer Reihe von seriegeschalteten Leistungshalbleiterbauelementen, indem die Leckströme aller Leistungshalbleiterbauelemente dem grössten Leckstrom angepasst werden. Die anzulegenden Steuerströme liegen in der Grössenordnung der Leckströme.

Ähnliche Steuerungen sind auch dynamisch möglich, so dass über die Steuerelektrode auch Unterschiede der Rückstromspitzen, der Sperrverzögerungszeiten und der auszuräumenden Ladung ausgeglichen werden können. Zudem ist es möglich, über die Steuerelektrode das harte Stromabreissen herkömmlicher Dioden ganz zu vermeiden.

Im ausgeschalteten, sperrenden Zustand des Leistungshalbleiterbauelements kann über die Steuerelektrode kurzzeitig ein Strom in der Grössenordnung des maximalen Kathodenstroms eingespiesen werden. Je nach Schaltung eines Umrichters ist es dadurch möglich, dass das erfindungsgemässe Leistungshalbleiterbauelement nicht bloss als Einzelelement auf einfache Art serieschaltbar wird, sondern dass sie die ausgleichende Funktion auch für weitere, zu ihm parallel geschaltete Komponenten übernimmt, z.B als Freilaufdiode für einen parallelen GTO oder IGBT. Die durch Unterschiede im Schaltverhalten der seriengeschalteten aktiven Leistungshalbleiter entstehenden Überspannungen an den einzelnen Leistungshalbleitern können durch kurzfristige Übernahme des Stromes durch die erfindungsgemässen Leistungshalbleiterbauelemente begrenzt werden.

Weitere vorteilhafte Ausführungsformen ergeben sich aus den abhängigen Ansprüchen.

### Kurze Beschreibung der Zeichnungen

Beispielhafte Ausführungsformen der Erfindung und damit erzielbaren weiteren Vorteile werden anschliessend anhand von Zeichnungen näher erläutert. Hierbei zeigen:
- Fig. 1: eine Draufsicht auf eine erste Ausführungsform des erfindungsgemässen Leistungshalbleiterbauelements mit einer wabenförmigen Steuerelektroden-/ Kathodenstruktur,
- Fig. 2: eine Draufsicht auf eine zweite Ausführungsform des erfindungsgemässen Leistungshalbleiterbauelements mit einer kreisförmigen Kathodenstruktur und einer zentralen Steuerelektrode,
- Fig. 3: eine perspektivische Ansicht in Pfeilrichtung der entlang III-III geschnittenen ersten Ausführungsform gemäss Fig. 1,
- Fig. 4: eine Ansicht in Pfeilrichtung der entlang IV-IV geschnittenen ersten Ausführungsform gemäss Fig. 1,
- Fig. 5: Messwerte von Messungen an einem erfindungsgemässen Leistungshalbleiterbauelement im stationären Betrieb im sperrenden Zustand bei einer Junction-Temperatur von 25°C,
- Fig. 6: Messwerte von Messungen an einem erfindungsgemässen Leistungshalbleiterbauelement in einer Schaltung antiparallel zu einem aktiven Halbleiterelement im stationären Betrieb im sperrenden Zustand,
- Fig. 7: Messwerte von Messungen an einem erfindungsgemässen Leistungshalbleiterbauelement in einer Schaltung antiparallel zu einem aktiven Halbleiterelement im dynamischen Betrieb im Übergang vom leitenden zum sperrenden Zustand, und
- Fig. 8: ein Schaltsymbol des erfindungsgemässen Leistungshalbleiterbauelements.

### Weg zur Ausführung der Erfindung

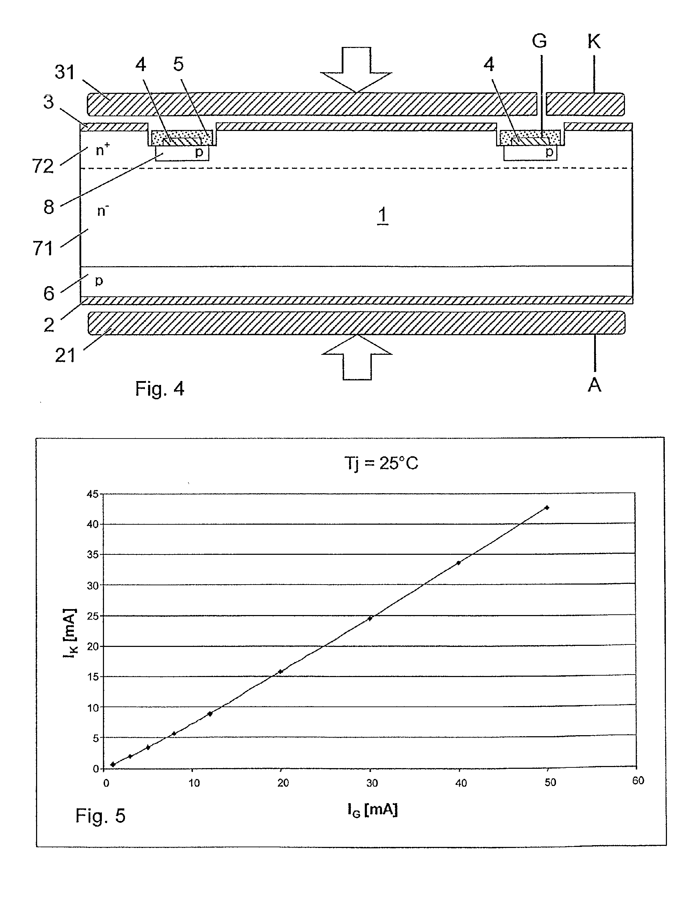

Der Aufbau des erfindungsgemässen Leistungshalbleiterbauelements wird anhand von Fig. 4 erläutert. Die Darstellung zeigt einen Schnitt durch eine erste mögliche Ausführungsform.

Ein vorteilhafterweise scheibenförmig ausgebildeter Halbleiterkörper 1 ist auf beiden gegenüberliegenden Hauptflächen grossflächig über Leistungselektroden kontaktierbar. In der Figur ist untenliegend auf der ersten Hauptfläche die Anodenelektrode 2 und gegenüberliegend auf der oberen, zweiten Hauptfläche die Kathodenelektrode 3 dargestellt.

Der Halbleiterkörper 1 ist wie eine herkömmliche Leistungsdiode in zwei hoch dotierte Zonen von unterschiedlichem Leitfähigkeitstyp unterteilt, welche an ihrer Schnittebene einen pn-Übergang bilden, wobei eine der beiden Zonen im Bereich der Schnittebene eine schwach dotierte Mittelschicht aufweist, in der sich die Raumladungszone ausbreiten kann.

Die erste Zone umfasst eine anodenseitige p-dotierte Schicht 6, die zweite Zone umfasst eine innere n⁻-dotierte Schicht 71 und eine kathodenseitige n⁺-dotierte Schicht 72. Die Auslegung der Dotierungen wird vorteilhafterweise herkömmlichen Leistungsdioden (hohe Betriebsspannung, hohe Schaltfrequenzen und hohe Schaltströme) entsprechend gewählt.

Typischerweise weist die anodenseitige p-dotierte Schicht 6 eine Randkonzentration von 5E+17 cm⁻³ Bor auf. Die kathodenseitige n⁺-dotierte Schicht 72 hat eine Randkonzentration von 1E+20 cm⁻³ Phosphor. Die innere, innere n⁻-dotierte Schicht 71 wird bei Hochspannungs-Leistungsdioden üblicherweise in einem Dotierungsbereich zwischen 4E+12 und 1.2E+13 cm⁻³ Phosphor dimensionniert.

Die Kathodenelektrode 3 des erfindungsgemässen Leistungshalbleiterbauelements ist in einzelne Inseln aufgeteilt. Dazwischen ist eine Steuerelektrode 4 angebracht, welche auf einer p-dotierten Schicht 8 angebracht ist. Die Steuerelektodenschicht 8 ist vollständig in die darunterliegende n⁺-dotierte kathodenseitige Schicht 72 eingebetet. Zwischen der Steuerelektrodenschicht 8 und der inneren, schwach dotierten Schicht 71 liegt somit ein hoch dotierter Bereich.

Die Steuerelektrode 4 ist gegenüber der Kathodenelektrode 3 abgesenkt. Bei der Kontaktierung der Leistungselektroden durch Druckscheiben 21 und 31 werden kathodenseitig alle Elektroden-Inseln miteinander zu einer einzigen Kathodenelektrode verbunden, während die abgesenkte Steuerelektrode 4 durch einen Isolationsabstand und eine zusätzliche Isolationsschicht 5 von der Druckscheibe 31 elektrisch isoliert bleibt.

Die Steuerelektrode 4 ist in der ersten Ausführungsform des erfindungsgemässen Leistungshalbleiterbauelements als fein verteilte aber zusammenhängende, die Kathodenelektroden-Inseln 3 umschliessende Elektrode ausgebildet. Die Steuerelektrode 4 wird lateral, beispielsweise zwischen zweiter Hauptfläche und der entsprechenden Druckscheibe aus dem Bauelement geführt und mit einem externen Anschluss kontaktiert (nicht dargestellt).

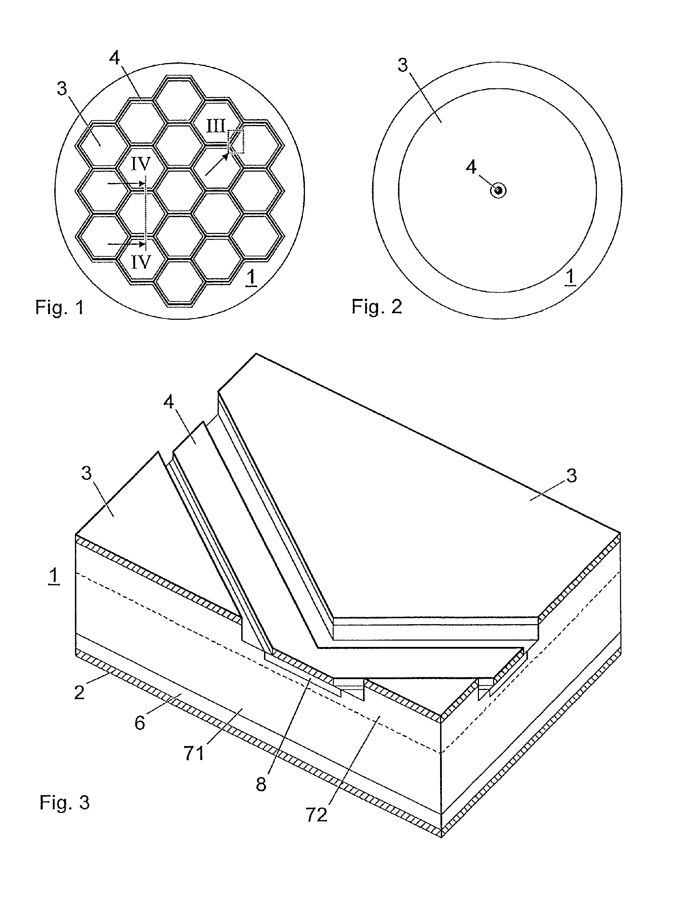

Eine mögliche Struktur der kathodenseitigen, zweiten Hauptfläche des erfindungsgemässen Leistungshalbleiterbauelements ist in Fig. 1 in einer Draufsicht von oben auf die zweite Hauptfläche dargestellt. Die Kathodenelektroden-Inseln 3 sind sechseckig ausgebildet und von der fein strukturierten Steuerelektrode 4 umgeben.

Fig. 3 zeigt einen vergrösserten Ausschnitt der Ausführungsform gemäss Fig. 1 mit den grossflächigen, sechseckigen Kathodenelektroden-Inseln 3 und der dazwischenliegenden Steuerelektrode 4.

Die Kathodenelektrode 3 und die darunterliegende n⁺-dotierte Schicht 72, sind derart grossflächig ausgelegt, dass sie im Betriebszustand den vollen Laststrom kontinuierlich führen können. Die Kathodenelektrode 3 bedeckt eine Fläche, welche grösser ist als die von der Steuerelektrode 4 bedeckte Fläche. Vorteilhafterweise ist die von der Kathodenelektrode 3 bedeckte Fläche mindestens 50% grösser als die von der Steuerelektrode 4 bedeckte Fläche.

Die hochdotierten Emitterschichten 6 und 72 der Diode werden im Wesentlichen mit bekannten Diodenprozesse hergestellt, wobei der p-Emitter gemäss einem vorgezogenen Verfahren durch Bor-Implantation, der n-Emitter durch Abscheidung eines Phosphorglases realisiert wird. Danach wird auf der Kathode in Bereichen der Steuerelektrode eine strukturierte Silizium-Ätzung definierter Tiefe vorgenommen. In einem letzten Silizium-Prozessschritt wird im gleichen Steuerelektrodenbereich Bor implantiert und in die gewünschte Tiefe eindiffundiert. Diese Herstellung der p-dotierten Steuerelektrodenschicht kann selektiv durch maskierte Implantation oder ganzflächig erfolgen, je nachdem ob eine rückwärtssperrende Eigenschaft der Steuerelektrode gefordert ist oder nicht.

Da die vollständige Einbettung der Steuerelektrodenschicht 8 in die n⁺-dotierte kathodenseitige Schicht 72 ein wesentliches Merkmal der neuen Diodenstruktur darstellt, hat es sich als vorteilhaft erwiesen, die Schicht 72 in einem zweistufigen Schritt als Doppelprofil auszubilden. Dabei wird in einem ersten Herstellungsprozess Phosphor auf die Kathodenseite implantiert und verhältnismässig tief eindiffundiert. Danach wird der eigentliche Kathodenemitter mittels chemischer Abscheidung eines Phosphorglases angebracht. Danach ist es einfach, die strukturierte Silizium-Ätzung derart vorzunehmen, dass sie den stark dotierten eigentliche Kathodenemitter ganz durchdringt und den implantierten Teil der Schicht 72 im wesentlichen stehen lässt. Es ist damit möglich, die Steuerelektrodenschicht 8 in einem Teil der Schicht 72 bekannter Konzentration auszubilden und damit die Empfindlichkeit der Steuerelektrode genau zu steuern.

Die Anbringung der Metallelektroden, die Randbearbeitung sowie eine eventuelle Passivierung der Steuerelektrodenbereiche erfolgt nach herkömmlichem Stand der Technik.

Die p-leitende Steuerelektrodenschicht 8 des erfindungsgemässen Leistungshalbleiterbauelements ist dank der darunterliegenden, durchgehenden n⁺-dotierten Schicht 72 auch im sperrenden Zustand stets in einer feldfreien Zone. Falls diese n⁺-dotierte Schicht überall eine ausreichend gute Querleitfähigkeit aufweist, verhält sich das erfindungsgemässe Leistungshalbleiterbauelements bei kurzgeschlossener, mit der Kathode K verbundener Steuerelektrode G wie eine herkömmliche Leistungsdiode mit normaler, durchgehender Kathode.

Wird zwischen Steuerelektrode G und Kathode K jedoch ein positiver Steuerelektrodenstrom eingespiesen, so erreicht ein Teil der in die n⁺-dotierte Schicht injizierten Löcher im Sperrfall die Raumladungszone 71 und wird über die Anode A abgesaugt. Dies bewirkt einen kontrollierten Anstieg des anodenseitigen Stromes. Dieser wird aufgrund der fein verteilten Struktur über einen Grossteil der aktiven Fläche eingespiesen, fliesst also quasi homogen durch das Element, ohne es zu gefährden. Von der Steuereinheit ist der Steuerelektrodenstrom bloss gegen eine Dioden-Vorwärtsspannung einzuspeisen. Allerdings erfordert eine verzögerungsfreie Einspeisung des Stromes im dynamischen Fall der raschen Strom-Abkommutierung eine entsprechend niederinduktive Ansteuerung, wie sie beispielsweise für GCT in EP 0 588 026 beschrieben ist.

Die Auslegung der lateralen Strukturierung der Kathode ist derjenigen eines abschaltbaren Thyristors (GTO, GCT) verwandt, ihre optimale Ausgestaltung unterscheidet sich aber doch deutlich. Während beim GTO die Emitter-Injektion (Elektronen) in der Mitte der Kathodensegmente beginnt und endet, tut dies beim erfindungsgemässen Leistungshalbleiterbauelement die Steuerelektroden-Injektion (Löcher) in der Mitte der Steuerelektrodenbereiche. Während also die Haupt-Designregel des GTO überall gleich breite Kathodensegmente verlangt, ist die Auslegung des erfindungsgemässen Leistungshalbleiterbauelements optimal mit überall gleich breiten Steuerelektroden-Bahnen. Zudem ist der Rand des GTO zur Stromentlastung ohne Kathodensegmente ausgeführt, während beim erfindungsgemässen Leistungshalbleiterbauelement der Rand ohne Steuerelektroden-Bereiche sein sollte, um dort keine Ströme zu injizieren.

Die Feinheit der Steuerelektrodenstruktur richtet sich nach der Grösse des einzuspeisenden Steuerelektrodenstromes und nach der dafür notwendigen Homogenität.

Soll zum Beispiel nur ein Leckstrom statisch ausgeglichen werden, kommt unter Umständen auch eine zentrale, punktuelle Einspeisung in Frage. Die Struktur der kathodenseitigen, zweiten Hauptfläche einer solchen zweiten Ausführungsform des erfindungsgemässen Leistungshalbleiterbauelements ist in Fig. 2 in einer Draufsicht von oben auf die zweite Hauptfläche dargestellt. Die Kathodenelektrode ist grossflächig ausgebildet und umschliesst in der Mitte die Steuerelektrode 4.

Die Steuerelektrode ist nicht dazu vorgesehen, das erfindungsgemässe Leistungshalbleiterbauelement als aktives Element zu steuern oder zu schalten. Sie ist vielmehr zur Beeinflussung der Parameter vorgesehen, welche die Abweichung von der idealen Diode charakterisieren.

Im Betrieb weist das erfindungsgemässe Leistungshalbleiterbauelement verschiedene vorteilhafte Eigenschaften auf.

Der Reverse-Recovery-Strom des erfindungsgemässen Leistungshalbleiterbauelements kann im Gegensatz zur Standarddiode über die zusätzliche Steuerelektrode gesteuert werden. Ein positiver Steuerelektrodenstrom zwischen Steuerelektrode und Kathode bewirkt einen Anstieg des anodenseitigen Stroms. Bei einer Auslegung des Halbleiterkörpers auf minimale Schaltverluste kann ein damit verbundener übermässig schnell abfallender Reverse-Recovery-Strom mittels dem Steuerelektrodenstorm gesteuert und so gleichmässig auf Null geführt werden. Überspannungen in der Stromrichterschaltung lassen sich so umgehen.

In der Serieschaltung von Dioden ohne Steuerelektroden können in einem Schaltvorgang die unterschiedlichen reverse-recovery Ladungen der einzelnen Bauelemente zu grossen Unterschieden in ihrer Spannungsbelastungen und letztendlich zur ihrer Zerstörung fühern. In einer Serieschaltung der erfindungsgemässen Leistungshalbleiterbauelementen kann im Fall einer Überspannung die positive Steuerelektrode so gesteuert weden, dass sich beim gegebenen Kathodenstrom die Anode-Kathode Spannung senkt. Eine Parallelschaltung von Snubbern zu den Leistungshalbleiterbauelementen ist damit nicht mehr erforderlich. Obwohl die Steuerung des Diodenverhaltens zu zusätzlichen Verlusten im Bauelement führt sind diese erheblich geringer als die in einer Snubberschaltung. Eine Snubberschaltung ist ausgelegt auf die maximale Schaltdifferenz von seriegeschalteten Dioden und erzeugt unahbhängig von der Diode-Auslegung eine maximale Verlustleistung.

Die Steuerelektrode des erfindungsgemässen Leistungshalbleiterbauelementes erlaubt, wie bereits oben erwähnt, den Leckstrom im sperrenden Zustand anzuheben. Im stationären sperrenden Zustand von mehreren seriegeschalteten Leistungshalbleiterbauelementen können die Unterschiede der Leckströme der einzelnen Leistungshalbleiterbauelementen mittels eines Steuerelektrodenstromes kompensiert werden. Ein Steuerelektrodenstrom proportional zum Unterschied zwischen dem momentanen und dem stationär maximal zulässigen Wert der Anode-Kathodespannung ergibt in der Serieschaltung der erfindungsgemässen Leistungshalbleiterbauelemente eine gleichmässige Spannungsverteilung. Hierbei liegt der Steuerelektrodenstrom in derselben Grössenordnung der Leckströme der Leistungshalbleiterbauelemente.

Im Sperrbetrieb des erfindungsgemässen Leistungshalbleiterbauelementes kann die Steuerelektrode auch kurzeitig mit einem Strom in der Grössenordnung des maximalen Kathodenstroms betrieben werden. Dieser Betriebsmodus bietet die Möglichkeit zum Einsatz des erfindungsgemässen Leistungshalbleiterbauelementes als antiparallele Diode zu aktiven Leistungshalbleiter (IGBT, GTO, ....) in Stromrichterserieschaltungen. Leichte Unterschiede im Schaltverhalten dieser Leistungshalbleiter können zu einer starken Spannungsbelastung führen. An seriegeschalteten aktiven Halbleitern, bei denen der Strom schnell abfällt, kann durch Parallelschalten von erfindungsgemässen Leistungshalbleiterbauelementen die Überspannung begrenzt werden. Steigt bei einem, in der Abschaltphase mit konstantem Strom belasteten aktiven Halbleiter, die Spannung zu schnell an, kann der Strom vom antiparallelgeschalteten erfindungsgemässen Leistungshalbleiterbauelement übernommen und so die Spannungsbelastung am aktiven Halbleiter begrenzt werden.

Die Eigenschaften des erfindungsgemässen Leistungshalbleiterbauelementes sind anhand von Messungen sowohl im stationären als auch im dynamischen Betrieb verifiziert worden.

Die Messergebnisse an einem erfindungsgemässen Leistungshalbleiterbauelement mit einer maximal zulässigen Belastung von 4500V/4000A bei einer Junction-Temperatur von 25° ist in Fig. 5 dargestellt. Das Diagramm zeigt, dass der Leckstrom I_{K} proportional zum positiven Steuerelektrodenstrom I_{G} steigt. Der Verstärkungsfaktor ist leicht temperaturabhängig.

In der Serieschaltung von herkömmlichen Dioden ohne Steuerelektrode kann eine Symmetrierung der Spannungsverteilung erreicht werden durch Parallelschaltung eines Widerstandes zu jeder Diode. Dieser Widerstand ist so dimensioniert, dass eine maximale Differenz der Leckströme von zwei seriegeschalteten Dioden zu einem begrenzten Anstieg in der Spanunngsbelastung der Diode führt. Wie bei der Snubberschaltung im dynamischen Betrieb, werden durch die statische Symmetrierung im parallegeschalteten Widerstand erhebliche Verluste erzeugt, selbst dann, wenn sich die Leckströme von seriegeschalteten Dioden nicht unterscheiden.

Der Einsatz der erfindungsgemässen Leistungshalbleiterbauelemente bringt den Vorteil, dass nur eine Differenz der Leckströme zu einer zusätzliche Verlustleistung in der Stromrichterschaltung führt.

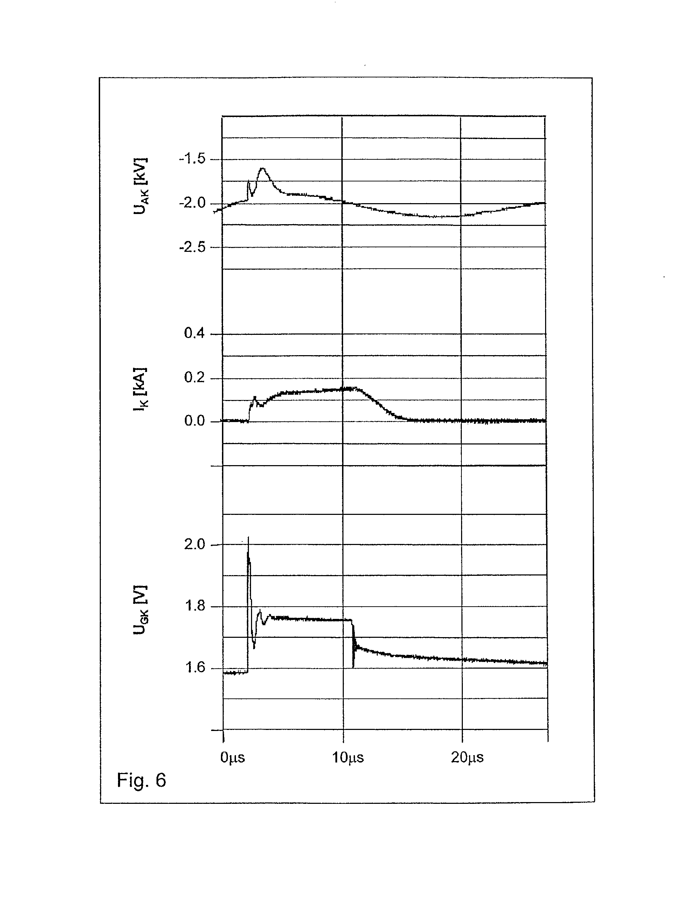

Für die Messung der stationären Eigenschaften wurde ein erfindungsgemässes Leistungshalbleiterbauelement mit einer Spannung U_{AK} von -2400 V belastet. Der pn-Übergang ist damit im Sperrbetrieb. Ein positiver Steuerelektrodenstrom sorgt für eine Injektion von Ladungsträgern und lässt damit den Sperrstrom steigen. Fig. 6 zeigt die Messergebnisse in diesem Betriebsmodus. Bei einer Sperrspannung von -2400 V wurde mittels einem durch eine positive Spannung U_{GK} an der Steuerelektrode erzeugten Steuerelektrodenstrom der Sperrstrom I_{K} auf 150A geführt. Der Verstärkungsfaktor zwischen Steuerelektrodenstrom und Kathodenstrom ist ungefähr 1.

Eine ähnliche Messung wurde im dynamischen Zustand des erfindungsgemässen Leistungshalbleiterbauelementes durchgeführt. Die Steuermethode des erfindungsgemässen Leistungshalbleiterbauelementes kann benutzt werden um Überspannungen an seriegeschalteten Bauelementen im Reverse-Recovery-Zustand zu beschränken.

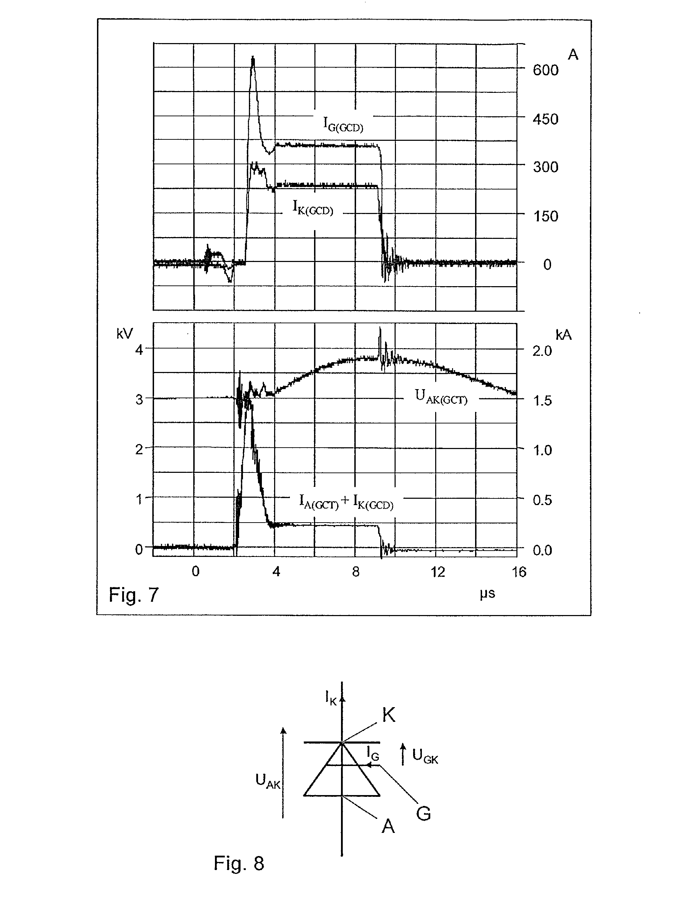

Fig. 7 zeigt den Betrieb des erfindungsgemässen Leistungshalbleiterbauelements parallelgeschaltet zu einem GCT im dynamischen GCT-Abschaltvorgang im Betriebspunkt 1500A/3000V. Bereits vor und während dem Abschaltvorgang kann die Steuerelektrode mit einem positiven Steuerelektrodenstrom gesteuert werden. Der Kathoden- und Steuerelektrodenstrom sowie die Anoden-Kathodenspannung des erfindungsgemässen Leistungshalbleiterbauelements sind im oberen Diagramm der Fig. 7 dargestellt. Im unteren Diagramm ist die Summe des Kathodenstroms des erfindungsgemässen Leistungshalbleiterbauelements und des Anodenstrom des parallelgeschalteten GCTs dargestellt. Der Tailbereich des GCT-Stromverlaufs entspricht dem reverse-recovery Vorgang in einer kurz zuvor von Ladungsträgern überfluteten herkömmlichen PSnN-Diode. Der Strom in dem erfindungsgemässen Leistungshalbleiterbauelement ist proportional zu seinem Gatestrom. Es ist deutlich zu erkennen, dass solange ein positiver Steuerelektrodenstrom eingespiesen wird, die Summe der Ströme sich im Tailbereich gezielt steuern lässt, bis hinzu über einen längeren Zeitbereich konstant gehalten werden kann. Erst wenn der Steuerelektrodenstrom abfällt, fällt auch der Tailstrom entsprechend schnell auf Null ab.

Auf diese Weise lässt sich in dem erfindungsgemässen Leistungshalbleiterbauelement das Reverse-Recovery-Verhalten steuern. Überspannungen in Serienschaltungen können so umgangen werden.

Das erfindungsgemässe Leistungshalbleiterbauelement lässt sich auch mit einer anodenseitigen Steuerelektrode realisieren. Diese wird auf einer entsprechenden n⁺ -dotierten Steuerelektrodenschicht angebracht, welche vollständig in die anodenseitige p⁺ -dotierte Zone eingebetet ist.

### Bezugszeichenliste

- 1: Halbleiterkörper
- 2: Leistungselektrode, Anode
- 3: Leistungselektrode, Kathode
- 4: Steuerelektrode
- 5: Isolation
- 6: Anodenseitige p-dotierte Halbleiterschicht
- 72: Kathodenseitige n-dotierte Halbleiterschicht
- 71: Innere, schwach n-dotierte Halbleiterschicht
- 8: p-dotierte Steuerelektrodenschicht
- 21, 31: Leistungsanschlüsse, Druckscheiben

## Patentansprüche

1. Verfahren zum Ansteuern einer Leistungsdiode mit einem Halbleiterkörper (1), welcher zwei je mittels einer Leistungselektrode (2, 3) kontaktierbare Zonen (6; 71, 72) umfasst, welche Zonen von unterschiedlichem Leitfähigkeitstyp sind und an der Schnittebene einen pn-Übergang bilden; wobei im Bereich einer zweiten der beiden Leistungselektrode (3) eine Steuerelektrode (4) eingelassen ist, welche von der Leistungselektrode elektrisch isoliert angeordnet ist, und welche direkt auf einer Schicht (8) im Halbleiterkörper angebracht ist, welche vollständig in die angrenzende Zone (72) eingebetet ist, von einem anderen Leitfähigkeitstyp als diese angrenzende Zone (72) ist und an der Schnittstelle zur angrenzenden Zone (72) mit der angrenzenden Zone einen pn-Übergang bildet; bei welchem Verfahren
durch Anlegen eines Stromes zwischen Steuerelektrode (4) und zweite Leistungselektrode (3), ein durch die andere, erste Leistungselektrode (2) fliessender Strom angehoben wird.

2. Verfahren nach Anspruch 1, **dadurch gekennzeichnet, dass**
beim Übergang vom Leitenden in den sperrenden Zustand der Diode der schnell abfallende reverse-recovery Strom durch den über die Steuerelektrode (4) eingespiesenen Steuerelektrodenstrom angehoben und anschliessend durch Reduzieren des Steuerelektrodenstromes gleichmässig gegen Null geführt wird.

3. Verfahren nach Anspruch 1, **dadurch gekennzeichnet, dass**
Im sperrenden Zustand der Diode der Leckstrom durch den über die Steuerelektrode (4) eingespiesenen Steuerelektrodenstrom angehoben wird.

4. Verfahren nach Anspruch 3, **dadurch gekennzeichnet, dass**
über die Steuerelektrode (4) kurzzeitig ein Steuerelektrodenstrom in der Grössenordnung des maximalen Stromes durch die erste Leistungselektrode eingespiesen wird.

5. Schaltungsanordnung zum Durchführen des Verfahrens nach einem der Ansprüche 1 bis 4, umfassend
mindestens zwei elektrisch in Serie geschaltete Leistungsdioden, wobei
mindestens eine dieser Leistungsdioden eine Steuerelektrode zum Einspeisen eines Steuerelektrodenstromes aufweist, wobei eine solche Leistungsdiode einen Halbleiterkörper (1) mit zwei je über eine Leistungselektrode (2, 3) kontaktierbaren Zonen (6; 71, 72) umfasst, welche Zonen von unterschiedlichem Leitfähigkeitstyp sind und an der Schnittebene einen pn-Übergang bilden; wobei
im Bereich einer der beiden Leistungselektroden (3) die Steuerelektrode (4) eingelassen ist, die von der Leistungselektrode elektrisch isoliert angeordnet ist, und die direkt auf einer Schicht (8) im Halbleiterkörper angebracht ist, welche vollständig in die angrenzende Zone (72) eingebetet ist, von einem anderen Leitfähigkeitstyp als diese angrenzende Zone (72) ist und an der Schnittstelle zur angrenzenden Zone (72) mit der angrenzenden Zone einen pn-Übergang bildet.

6. Schaltungsanordnung zum Durchführen des Verfahrens nach einem der Ansprüche 1 bis 4, umfassend
eine Parallelschaltung von mindestens einem aktiv abschaltbaren Leistungshalbleiterbauelement mit mindestens einer Leistungsdiode,
wobei mindestens eine Leistungsdiode eine Steuerelektrode zum Einspeisen eines Steuerelektrodenstromes aufweist;
wobei diese Leistungsdiode einen Halbleiterkörper (1) mit zwei je über eine Leistungselektrode (2, 3) kontaktierbaren Zonen (6; 71, 72) umfasst, welche Zonen von unterschiedlichem Leitfähigkeitstyp sind und an der Schnittebene einen pn-Übergang bilden;
wobei im Bereich einer der beiden Leistungselektroden (3) die Steuerelektrode (4) eingelassen ist, die von der Leistungselektrode elektrisch isoliert angeordnet ist, und die direkt auf einer Schicht (8) im Halbleiterkörper angebracht ist, welche vollständig in die angrenzende Zone (72) eingebetet ist, von einem anderen Leitfähigkeitstyp als diese angrenzende Zone (72) ist und an der Schnittstelle zur angrenzenden Zone (72) mit der angrenzenden Zone einen pn-Übergang bildet.
